(19) Europäisches Patentamt / European Patent Office / Office européen des brevets

(11) **EP 3 274 480 B1**

(12) **FASCICULE DE BREVET EUROPEEN**

(45) Date de publication et mention de la délivrance du brevet:
**21.10.2020 Bulletin 2020/43**

(21) Numéro de dépôt: **16718393.8**

(22) Date de dépôt: **21.03.2016**

(51) Int Cl.:
*C22C 5/02* (2006.01)          *B32B 15/01* (2006.01)
*C23C 14/00* (2006.01)          *C23C 14/14* (2006.01)
*C23C 14/20* (2006.01)          *C23C 14/24* (2006.01)
*C23C 30/00* (2006.01)

(86) Numéro de dépôt international:
**PCT/FR2016/050618**

(87) Numéro de publication internationale:
**WO 2016/151228 (29.09.2016 Gazette 2016/39)**

(54) **ALLIAGE MONOPHASIQUE D'OR ET DE TUNGSTENE**

EINPHASIGE LEGIERUNG AUS GOLD UND WOLFRAM

SINGLE-PHASE ALLOY OF GOLD AND TUNGSTEN

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.03.2015 FR 1552363**

(43) Date de publication de la demande:
**31.01.2018 Bulletin 2018/05**

(73) Titulaire: **Centre National de la Recherche Scientifique**
**75016 Paris (FR)**

(72) Inventeur: **DERANLOT, Cyrile**
**75015 Paris (FR)**

(74) Mandataire: **IP Trust**
**2, rue de Clichy**
**75009 Paris (FR)**

(56) Documents cités:
**JP-A- 2012 212 662     US-A1- 2011 006 426**

- **SVEN HAMANN ET AL: "Synthesis of Au microwires by selective oxidation of Au-W thin-film composition spreads", SCIENCE AND TECHNOLOGY OF ADVANCED MATERIALS, vol. 14, no. 1, 7 février 2013 (2013-02-07), page 015003, XP055250552, ISSN: 1468-6996, DOI: 10.1088/1468-6996/14/1/015003**

- **OSSI ET AL: "Model of phase formation in ion-mixed binary alloys with positive heats of formation", JOURNAL OF THE LESS-COMMON METALS, ELSEVIER-SEQUOIA S.A. LAUSANNE, CH, vol. 160, no. 2, 1 mai 1990 (1990-05-01), pages 351-362, XP024073636, ISSN: 0022-5088, DOI: 10.1016/0022-5088(90)90393-X [extrait le 1990-05-01]**

- **L Velasco ET AL: "The corrosion resistance and microstructure of UBM system-deposited NbxSiyNz thin films Resistencia a la corrosión y microestructura de recubrimientos de NbxSiyNz depositadas con el sistema UBM", DECEMBER, 3 décembre 2012 (2012-12-03), pages 10-13, XP055275167, Extrait de l'Internet: URL:http://www.bdigital.unal.edu.co/35567/ 1/35932-148095-1-PB.pdf [extrait le 2016-05-25]**

- **ZHANG R F ET AL: "Study of metastable alloy formation by thermodynamic calculation and ion beam manipulation in an equilibrium immiscible Au-W system", JOURNAL OF ALLOYS AND COMPOUNDS, ELSEVIER SEQUOIA, LAUSANNE, CH, vol. 375, no. 1-2, 28 juillet 2004 (2004-07-28), pages 179-185, XP004517542, ISSN: 0925-8388, DOI: 10.1016/J.JALLCOM.2003.11.132**

**Description**

Domaine de l'invention

La présente invention concerne le domaine des alliages métallurgiques appelés or blanc ou or gris. L'or blanc est un alliage utilisé notamment dans le domaine de la joaillerie en raison de sa teinte à l'état naturel proche de celle de l'argent - avec un éclat et une longévité bien plus importants. Pour lui donner sa coloration finale lumineuse et claire, l'or blanc est souvent recouvert d'une fine couche d'un métal rare, le rhodium.

L'or blanc est un matériau composé d'or associé à d'autres métaux, généralement le nickel, le palladium, le cuivre, le zinc.

Le problème lié à l'allergie provoquée par le nickel a conduit à la limitation, voire à l'interdiction totale de la présence de nickel dans les alliages d'or blanc ou gris. En plus, ces alliages sont excessivement durs et peu déformables de sorte qu'ils se prêtent mal au travail dans le domaine de la bijouterie et de l'horlogerie en particulier.

Le domaine de l'invention n'est pas celui de matériaux biphasiques ou multiphasiques composés d'une association de métaux de deux natures différentes sans structure cristalline unique.

Pour un alliage homogène monophasique au sens de la présente invention, l'élément d'addition remplace, dans la structure cristalline du métal de base, un atome du réseau atomique ou s'intercale dans la structure cristalline du métal de base.

Pour un matériau biphasique, les structures cristallines des deux métaux se juxtaposent pour former un matériau hétérogène dont les propriétés mécaniques et physiques sont fondamentalement différentes de celle d'un alliage monophasique homogène même si les proportions de métaux sont les mêmes.

Etat de la technique

Etat de la technique concernant des matériaux multiphasiques

On connaît en premier lieu dans l'état de la technique des documents concernant la formation de matériaux biphasiques d'or et de tungstène.

Il est cité comme D1 l'article de SVEN HAMANN ET AL: "Synthesis of Au microwires by selective oxidation of Au-W thin-film composition spreads", paru dans SCIENCE AND TECHNOLOGY OF ADVANCED MATERIALS, vol. 14, no. 1, 1 février 2013 (2013-02-01), page 015003, XP055250552, ISSN: 1468-6996, DOi: 10.1088/1468-6996/14/1/015003. Cette publication concerne la croissance de microfils formés par une matrice mélangeant de manière non homogènes de l'or et du tungstène. Ce document ne mentionne jamais la formation d'un alliage homogène, qui n'est pas l'objet des travaux. La figure 1b de ce document de l'art antérieur montre d'ailleurs parfaitement la dispersion en concentration des deux éléments à l'échelle du substrat : Il n'y a pas homogénéité de composition sur l'ensemble de l'échantillon. Ce document n'invoque jamais la formation d'un alliage homogène, et au contraire montre qu'il conduit à la préparation d'échantillons présentant des zones pures d'or et des zones pures de tungstène. A la page 4, dernier paragraphe de ce document, les auteurs admettent qu'à l'état initial (juste après dépôt), les échantillons "The diffraction patterns in the as-deposited state (not shown) indicate the presence of pure Au and W ». C'est clairement la preuve que ces échantillons ne sont pas monophasiques puisqu'ils contiennent au moins ces deux phases pures. Leur procédé de co-pulvérisation avec deux cibles en deux modes de décharges différents ne conduit donc pas à un alliage or-tungstène monophasique et homogène.

Il est cité comme D2, l'article de OSSI ET AL: "Model of phase formation in ion-mixed binary alloys with positive heats of formation", paru dans le JOURNAL OF THE LESS-COMMON METALS, ELSEVIER-SEQUOIA S.A. LAUSANNE, CH, vol. 160, no. 2, 1 mai 1990 (1990-05-01), pages 351-362, XP024073636, ISSN: 0022-5088, DOi: 10.1016/0022-5088(90)90393-X.

Cet article scientifique décrit des travaux expérimentaux relatés dans une autre publication citée en note 19. Il s'agit de l'article "Ion Beam Mixing of Selected Binary Metal Systems with Large Positive Heats of Formation" de W. HILLER, M. BUCHGEISTER, P. EITNER, K. KOPITZKI, V. LILIENTHAL and E. PEINER, Institut fiir Strahlen- und Kernphysik der Universitiit Bonn, Nussallee 14-16, D-5300 Bonn 1 (F.R.G.). Ce document référencé expose le mode de fabrication des échantillons objet de cet article OSSI et Al.

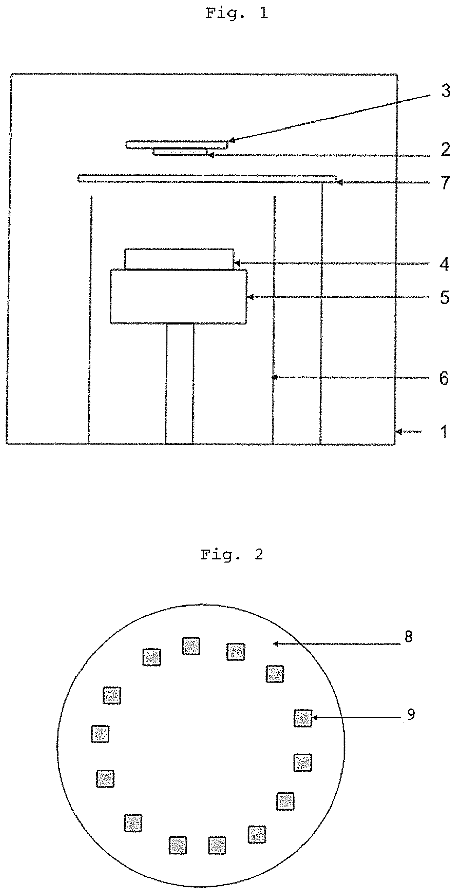

Il s'agit de dépôts alternés de couches minces d'Au pur et W pur réalisés par évaporation sous vide (canon à électrons). Les échantillons sont ensuite irradiés avec un faisceau d'ions Kr+ à 400keV. L'ion mixing est la définition des effets de diffusion des deux métaux (Au et W) sous l'effet de l'irradiation. La figure 1 de la référence 19 montre des spectres de diffraction X avant et après irradiation.

L'état non irradié montre clairement la présence de pics de diffraction relatifs à Au et W ce qui est une preuve que l'échantillon n'est pas monophasique.

Il ne peut d'ailleurs pas l'être puisqu'il est justement composé d'alternances de couches pures de chaque métal. La figure de cet article montre qu'il ne conduit en rien à la présence d'un alliage monophasique et homogène. L'argumentaire des auteurs va d'ailleurs dans ce sens.

Concernant la préparation de matériaux comprenant une phase d'or et une phase de tungstène, il est cité comme D3 le brevet japonais JP 2012 212662 concernant l'électronique organique dans lequel il est fait état (00141) d'un dépôt d'un matériau Au-W (80:20 en masse) par sputtering, conduisant comme pour les deux précédents document, à une structure hétérogène. Ce document n'évoque à aucun moment la réalisation d'un alliage homogène monophasique.

Etat de l'art concernant les matériau de type « or blanc »

On a déjà proposé dans le brevet suisse CH-684 616 un alliage d'or gris sans nickel présentant une bonne déformabilité, comprenant généralement dans ce cas essentiellement entre 15% et 17% en poids de palladium, entre 3 et 5% de magnésium et entre 5 et 7% en poids de cuivre.

On connaît aussi la demande de brevet EP2427582 qui concerne un alliage d'or blanc sans nickel et cuivre ayant une dureté qui convient en particulier pour les horlogers et bijoutiers. Cet alliage selon l'art antérieur est constitué de (% en poids): plus de 75% d'or, plus de 18% à moins de 24% de palladium, plus de 1% à moins de 6% d'au moins un élément choisi parmi Mn, Hf, Nb, Pt, Ta, V, Zn et Zr, et le cas échéant, pas plus de 0,5% d'au moins un élément choisi parmi Si, Ga et Ti et éventuellement, pas plus de 0,2% d'au moins un élément choisi parmi Ru, Ir et Re.

On connaît aussi par le brevet américain US6863746 une composition d'or blanc constitué essentiellement de cuivre, d'argent, de zinc et de manganèse, et comprenant en outre de faibles quantités d'étain, de cobalt, silicium / cuivre et de bore / cuivre.

Plus particulièrement, la composition d'or blanc de la présente invention décrit une composition d'or blanc constitué essentiellement d'environ 36% à environ 57% de cuivre, environ 10% d'argent, environ 18,2% à environ 24,2% de zinc, environ 14% à environ 28,9% de manganèse et le reste étant constitué en outre d'environ 1% d'étain, d'environ 0,025% à environ 0,03% de cobalt, environ 0,52% de silicium / de cuivre, et environ 0,2% de bore/cuivre.

La demande internationale WO2014108848 décrit une composition d'alliage destinée à la production d'alliages d'or, plus particulièrement d'alliages d'or blanc comprenant du rhodium (Rh) utilisé comme constituant de couche blanche et susceptible de réduire la libération de nickel lors de l'insertion du rhodium (Rh) dans des alliages contenant du nickel.

La demande de brevet EP2045343 décrit un autre alliage d'or blanc sans nickel contenant du gallium Ga comme agent de blanchiment.

Le brevet EP2450461 décrit un alliage d'or gris sans nickel et sans cuivre présentant une dureté convenant en particulier aux horlogers, bijoutiers et joailliers.

Cet alliage est constitué de (en pourcentages massiques) :

- plus de 75% d'Au ;
- de plus de 18% à moins de 24% de palladium ;
- de plus de 1% à moins de 6% de Zr ;
- éventuellement, de plus de 1% à moins de 6% d'au moins un élément choisi parmi Mn, Hf, Nb, Pt, Ta, V et Zn ;
- éventuellement, au plus 0,5% d'au moins un élément choisi parmi Si, Ga et Ti ; et
- éventuellement, au plus 0,2% d'au moins un élément choisi parmi Ru, Ir et Re.

Le brevet EP1010768 décrit un alliage d'or blanc sans nickel, destiné en particulier à la technique de coulée par cire perdue, comprenant, en poids, 75-76% d'or et entre 12 et 14% de palladium, entre 7 et 11% de Cu, entre 1 et 4% d'In, entre 0,2 et 0,4% de Ga, le reste étant formé par une proportion comprise entre 0,01 et 4% de l'un au moins des éléments Ir, Re, Zn, Nb, Si, Ta, Ti.

Inconvénients de l'art antérieur

Les solutions de l'art antérieur présentent différents inconvénients. Ces alliages présentent des caractéristiques physiques (masse volumique, dureté, ductilité, résistance à la corrosion, au ternissement et au jaunissement) qui ne sont pas totalement satisfaisantes.

Beaucoup de ces solutions utilisent du palladium, qui permet d'obtenir une bonne blancheur. Mais il s'agit d'un métal très cher et dont les cours fluctuent énormément, conduisant à des alliages trop mous en l'absence d'autres métaux ; de ce fait les solutions utilisant ce métal ne sont pas bien appropriées.

L'ajout de cuivre proposé dans la plupart des solutions de l'art antérieur permet certes de durcir les alliages mais son inertie thermique conduit a des difficultés lors de la coulée d'une pièce et provoque lors du traitement thermique, un durcissement non contrôlable et un risque de fissuration. Par ailleurs, le cuivre comporte un risque d'oxydation.

Pour la plupart des alliages de l'art antérieur contenant du Pd et/ou du Cu, il est nécessaire, pour obtenir la couleur et l'éclat du métal recherché, de procéder à un dépôt galvanique de rhodium. L'épaisseur de ce revêtement (quelques centaines de nanomètres) reste sensible au frottement et la couleur du substrat réapparaît ponctuellement, ce qui ne permet pas de réaliser des objets en or destinés à durer.

Afin de ne pas nécessiter de rhodiage, un alliage d'or doit garantir, d'après la norme ASTM Method D1925, une valeur YI : D1925 < 19 (YI : « yellowness index »), considérée comme « good white » ou « premium » et intégrée à la catégorie Grade 1 (voir Proceedings of Santa Fe Symposium 2005, pp. 103-120).

La valeur YI peut être transposée dans le système CIELab, CIE étant le sigle de la Commission Internationale de l'Eclairage et La*b* les trois axes de coordonnées, l'axe L mesurant la composante blanc-noir (noir = 0 et blanc = 100), l'axe a* mesurant la composante rouge-vert (rouge = valeurs positives, vert = valeurs négatives) et l'axe b* mesurant la composante jaune-bleu (jaune = valeurs positives, bleu = valeurs négatives). (Cf. norme ISO 7724 établie par la Commission Internationale de l'Eclairage). Les couleurs des alliages d'or sont définies dans l'espace tri-chromatique selon la norme ISO 8654. Une valeur YI < 19 correspond en première approximation à [-2 $\leq$ a* $\leq$ 2 ; b* < 10].

Solution apportée par l'invention

Afin de répondre à ces inconvénients, la présente invention concerne un nouveau matériau de type « or blanc » ou « or gris », constitué par un alliage monophasique homogène constitué, en pourcentage massique, par N% d'or, M% de tungstène, avec N+M=100, M $\geq$ 8 et N $\geq$ 60. L'homogénéité de l'alliage étant caractérisée par une seule phase chimique, sans présence d'amas, précipités ou agrégats de tungstène.

De préférence, N $\geq$ 75 et M $\leq$ 24.

L'alliage or-tungstène homogène et monophasique peut être appliqué pour des utilisations notamment :

- comme or blanc de grade 1 décoratif sous forme de couche mince ou de feuille
- comme sous couche à de l'or pur
- comme brique de base à partir de laquelle est préparé l'or blanc de grade 1 massif, alternative à un alliage d'or au nickel ou au palladium.

Dans cette dernières application, l'or blanc massif au tungstène ne sera sûrement pas homogène et monophasique à l'arrivée, mais ses propriétés mécaniques, de couleur, de coulabilité seront différentes de celles que présente un alliage d'or et de tungstène connu dans l'art antérieur, c'est-à-dire non homogène et multiphasique.

De préférence, l'alliage homogène et monophasique selon l'invention présente une masse volumique supérieure à 19,2 g/cm$^3$.

Selon un mode de réalisation préféré, l'alliage présente une structure cristallographique cubique faces centrées.

L'invention concerne également l'utilisation d'un tel alliage pour la réalisation d'une couche décorative, ainsi que pour la réalisation d'une feuille décorative pour la dorure à froid ou la réalisation d'une couche de support d'une couche d'or pur.

L'invention concerne aussi une feuille décorative constituée par un alliage monophasique homogène comprenant, en pourcentage massique, par N% d'or, M% de Tungstène, avec N+M=100, M $\geq$ 8 et N $\geq$ 60.

Optionnellement, cette feuille est une feuille multicouche, avec au moins une couche d'alliage revêtue par une couche d'or pur.

L'invention concerne encore un procédé de préparation d'un alliage monophasique homogène constitué, en pourcentage massique, par N% d'or, M% de Tungstène, avec N+M=100, M $\geq$ 8 et N $\geq$ 60 consistant à procéder au dépôt physique en phase vapeur respectivement de l'or et du tungstène, et de condensation des vapeurs des deux métaux sur un substrat, avec une technique de pulvérisation cathodique en mode diode avec un réacteur magnétron (5) et une décharge luminescente d'argon en utilisant une cible d'or-tungstène (4), qui est installée sur le réacteur magnétron (5), la surface totale des morceaux de tungstène (7) W étant choisie en fonction des paramètres de la décharge plasma utilisée afin d'obtenir un alliage $AU_{1-x}W_x$, x étant concentration atomique en tungstène, la relation liant la surface de tungstène et la concentration atomique de W(x) étant la suivante :

$$x(\%at.W) = \frac{R_W S_W}{R_W S_W + R_{Au}(S_T - S_W)}$$

avec $R_W$ = rendement de pulvérisation du tungstène à la tension de décharge,
$S_W$ = surface de tungstène,
$R_{au}$ = rendement de pulvérisation de l'or à la tension de décharge,
$S_T$ = surface totale de la cible.

De préférence, ledit substrat est préalablement revêtu d'une couche sacrificielle.

Selon une variante, le procédé comporte au moins une étape additionnelle de dépôt sous vide d'une couche d'or pur.

Description détaillée d'un exemple de réalisation non limitatif

L'invention sera mieux comprise à la lecture de la description qui suit concernant des exemples non limitatifs de réalisation où :

- la figure 1 représente une vue schématique d'une installation pour la formation d'une couche d'or blanc selon l'invention
- la figure 2 représente une vue de dessus d'un exemple de cible pour la mise en œuvre de l'invention
- La figure 3 illustre un exemple de spectre de réflectométrie de rayons X obtenu sur une couche mince d'alliage Au75W25.
- La figure 4 illustre un exemple de spectre de diffraction de rayons X obtenus sur une feuille d'alliage Au75W25.

L'invention concerne l'alliage monophasique d'or et de tungstène selon la revendication 1, qui présente une structure cristalline homogène, stable et répondant, notamment pour les alliages dont la proportion d'or de 75% et de 25% de tungstène, à la qualification d'or blanc prévoyant, d'après la norme ASTM Method D1925, une valeur YI : D1925 <19 (YI : Yellowness index) considérée comme « good white » ou « premium » et intégrée à la catégorie Grade 1.

Procédé de fabrication

L'alliage composé d'or (Au) et de tungstène (W) est obtenu sous forme de couche mince par dépôt physique en phase vapeur (PVD pour Physical Vapor Deposition en anglais). L'alliage monophasé présente une concentration massique de tungstène de 25% avec une répartition homogène des atomes de tungstène dans l'or. L'alliage ainsi obtenu présente une densité égale à celle de l'or pur, il est biocompatible de par la biocompatibilité des deux éléments, il est inoffensif pour l'environnement et facile à retraiter.

Cet alliage de composition Au75W25 présente une couleur d'or blanc de Grade 1 qui non seulement ne nécessite pas de rhodiage supplémentaire mais pourrait se substituer à cette phase de rhodiage pour obtenir un objet ne comportant que des alliages d'or. L'ensemble de ces propriétés rend cet alliage intéressant pour une utilisation comme couche décorative.

D'autre part, l'or étant un métal très inerte, il est difficile de le faire adhérer sur des surfaces. Il est donc souvent fait recours à un matériau getter (Ta, Cr, Va, Ti) afin de déposer une couche d'accrochage préalable au dépôt de la couche d'or. L'alliage AuW peut servir de support à une couche d'or pur dont on voudrait à la fois diminuer le coût de revient en terme de matière première tout en conservant la masse volumique de l'or pur.

L'alliage or-tungstène qui fait l'objet de cette invention est obtenu en mélangeant les vapeurs de chacun des métaux et en les condensant sur un substrat. Il existe plusieurs techniques PVD comme l'évaporation thermique, la pulvérisation cathodique, l'ablation laser pulsée.

L'exemple selon l'invention décrit est basé sur la technique de pulvérisation cathodique en mode diode avec un réacteur magnétron et une décharge luminescente d'argon (Ar).

D'autres modes de pulvérisation cathodique peuvent être utilisés ainsi que d'autres techniques PVD (évaporation thermique par exemple), dans des exemples comparatifs.

L'installation représentée en figure 1 comprend une enceinte généralement sous vide (1).

Le substrat (2) est monté sur son porte-substrat (3) et se trouve face à la cible d'or-tungstène (4). Cette dernière est installée sur un réacteur magnétron (5) comprenant un aimant annulaire entourant un aimant central cylindrique, de polarité inversée, qui assure la pulvérisation concomitante d'or et de tungstène. Les parois de confinement du plasma (6) permettent de limiter sa dispersion tandis que le cache amovible (shutter) (7) permet de contrôler l'épaisseur de la couche décorative en contrôlant son temps d'ouverture.

Cette technique met en œuvre un plasma afin d'extraire la matière d'une cible du matériau désiré sous forme de vapeur. Cette vapeur diffuse dans le plasma et vient se condenser sur le substrat pour former une couche mince. L'or et le tungstène étant non miscibles à l'équilibre thermodynamique, il n'est pas possible de pulvériser directement une cible de l'alliage monophasé Au-W désiré, cette dernière n'étant pas fabricable par les voies de métallurgie physique classiques.

La cible est constituée de ce fait d'un disque d'or pur (8) dont le diamètre correspond sensiblement au diamètre du réacteur magnétron (5) sur laquelle on dispose des morceaux de tungstène pur (7) suivant le schéma de la figure 2. Les morceaux de tungstène pur (7) sont répartis pour former une couronne dont le rayon correspond sensiblement au rayon médian de l'aimant annulaire du magnétron.

La surface totale des morceaux de tungstène (7) est choisie en fonction des paramètres de la décharge plasma utilisée afin d'obtenir un alliage Au1-xWx (x étant la concentration atomique en tungstène). La relation liant la surface de tungstène et la concentration atomique de W est la suivante :

$$x(\%at.W) = \frac{R_W S_W}{R_W S_W + R_{Au}(S_T - S_W)}$$

avec $R_W$ = rendement de pulvérisation du tungstène à la tension de décharge
$S_W$ = surface de tungstène
$R_{Au}$ = rendement de pulvérisation de l'or à la tension de décharge
$S_T$ = surface totale de la cible

Une fois la couche mince Au-W obtenue, sa densité est mesurée par réflectométrie des rayons X et dans tous les cas, elle est supérieure à 19.2g/cm$^3$.

L'homogénéité de l'alliage est caractérisée par microscopies électroniques (à balayage et/ou à transmission) associées à des techniques d'analyses chimiques du type EDS (Energy Dispersive Spectroscopy en anglais) ou WDS (Wavelength Dispersive Spectroscopy). Ces analyses montrent une seule phase chimique, sans présence d'amas, précipités ou agrégats de tungstène.

La cristallinité de l'alliage est caractérisée par diffraction des rayons x. Pour toutes les compositions, le spectre obtenu présente deux pics principaux proches des positions relatives aux plans (111) et (222) de l'or. Les couches minces d'Au-W sont polycristallines avec une texture de fibre (111) ce qui signifie que les grains composant l'alliage Au$_{75}$W$_{25}$ présentent des plans (111) parallèles à la surface et une orientation aléatoire de ces plans (111) dans le plan de la couche mince. Ces plans (111) correspondent aux plans denses d'une structure de type cubique faces centrées qui est la structure initiale de l'or pur.

La couleur des couches minces obtenues est, elle, mesurée par spectrocolorimétrie avec un illuminant C, un angle d'observation de 2° avec prise en compte des composantes spéculaire et ultraviolet. Dans cette configuration, les couleurs mesurées sur les couches minces de l'alliage Au$_{75}$W$_{25}$ (or 18 carats) présentent des coordonnées La*b* telles que L>75, -2<a*<2 et b*<10 soit des index YI<19.

Le substrat est un disque de verre sur lequel est déposée une couche de résine photosensible dont le solvant est l'acétone.

Le substrat est introduit dans le réacteur de pulvérisation cathodique dans lequel est placée la cible décrite sur la figure 2.

La cible est un disque en or pur (8) présente un diamètre de 75mm et la somme de la surface de tungstène (9) est de 976mm$^2$. Le réacteur plasma est mis en fonctionnement à une pression de 2.5.10$^{-1}$ Pa d'argon avec une distance entre la cible et le substrat de 12cm. Une fois la couche mince déposée sur le substrat, ce dernier est placé dans l'acétone afin de dissoudre la couche de résine photosensible et ainsi récupérer la feuille désolidarisée du substrat de verre.

De façon générale, le procédé décrit prévoit le dépôt des morceaux de tungstène de surface ad-hoc sur une cible d'or.

Une alternative à titre comparatif consiste à inverser la position de chaque métal (cible de tungstène et morceaux d'or), compte tenu des rendements de pulvérisation des deux métaux. Cette variante consiste alors à préparer l'alliage or-tungstène homogène et monophasique à partir d'une cible de tungstène sur laquelle on dépose des morceaux d'or.

Le coût de revient du procédé s'en trouve diminué de la proportion d'or utilisée nettement inférieure.

Cette feuille est analysée par réflectométrie et diffraction des rayons X.

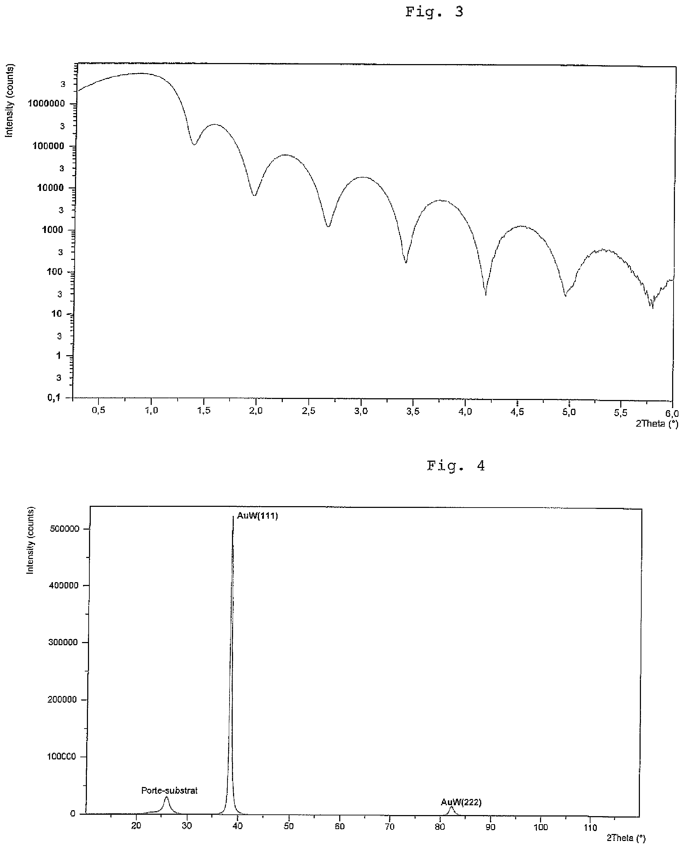

La figure 3 illustre un exemple de spectre de réflectométrie de rayons X obtenu sur une couche mince d'alliage Au75W25.

La figure 4 illustre un exemple de spectre de diffraction de rayons X obtenus sur une feuille d'alliage Au75W25.

**Revendications**

1.  Alliage monophasique homogène constitué, en pourcentage massique, par N% d'or, M% de Tungstène, avec N+M=100, M ≥8 et N ≥ 60, l'homogénéité de l'alliage étant **caractérisée par** une seule phase chimique, sans présence d'amas, précipités ou agrégats de tungstène.

**2.** Alliage monophasique homogène selon la revendication 1 **caractérisé en ce que** N $\geq$ 75.

**3.** Alliage monophasique homogène selon la revendication 2 **caractérisé en ce que** M $\leq$ 25.

**4.** Alliage monophasique homogène selon la revendication 3 **caractérisé en ce qu'**il présente une masse volumique supérieure à 19,2 g/cm$^3$.

**5.** Alliage monophasique homogène selon l'une quelconque des revendications précédentes **caractérisé en ce qu'**il présente une structure cristallographique cubique faces centrées.

**6.** Utilisation d'un alliage monophasique homogène selon l'une au moins des revendications 1 à 5 pour la réalisation d'une couche décorative.

**7.** Utilisation d'un alliage monophasique homogène selon l'une au moins des revendications 1 à 5 pour la réalisation d'une feuille décorative.

**8.** Utilisation d'un alliage monophasique homogène selon l'une au moins des revendications 1 à 5 pour la réalisation d'une couche de support d'une couche d'or pur.

**9.** Feuille décorative constituée par l'alliage monophasique homogène selon l'une au moins des revendications 1 à 5, comprenant, en pourcentage massique, N% d'or, M% de Tungstène, avec N+M=100, M $\geq$8 et N $\geq$ 60.

**10.** Feuille décorative selon la revendication précédente **caractérisé en ce qu'**elle est revêtue par une couche d'or pur.

**11.** Procédé de préparation de l'alliage selon l'une au moins des revendications 1 à 5, consistant à procéder au dépôt physique en phase vapeur respectivement de l'or et du tungstène, et de condensation des vapeurs des deux métaux sur un substrat avec une technique de pulvérisation cathodique en mode diode avec un réacteur magnétron et une décharge.

**12.** Procédé de préparation d'un alliage monophasique homogène selon la revendication précédente **caractérisé en ce que** ledit substrat est préalablement revêtu d'une couche sacrificielle.

**13.** Procédé de préparation d'un alliage monophasique homogène selon la revendication 11 ou 12 **caractérisé en ce qu'**il comporte au moins une étape additionnelle de dépôt sous vide d'une couche d'or pur.

**Patentansprüche**

**1.** Homogene einphasige Legierung, die in Massenprozent aus N% Gold, M% Wolfram mit N + M = 100, M $\geq$ 8 und N $\geq$ 60 besteht, wobei die Homogenität der Legierung durch eine einzige chemische Phase ohne das Vorhandensein von Klumpen, Niederschlägen oder Aggregaten von Wolfram gekennzeichnet ist.

**2.** Homogene einphasige Legierung nach Anspruch 1, **gekennzeichnet durch** N $\geq$ 75.

**3.** Homogene einphasige Legierung nach Anspruch 2, **gekennzeichnet durch** M $\leq$ 25.

**4.** Homogene einphasige Legierung nach Anspruch 3, **dadurch gekennzeichnet, dass** sie eine Dichte von mehr als 19,2 g/cm$^3$ aufweist.

**5.** Homogene einphasige Legierung gemäß einem der vorhergehenden Ansprüche, **gekennzeichnet dadurch, dass** sie eine kubische kristallographische Struktur mit zentrierten Flächen aufweist.

**6.** Verwendung einer homogenen einphasigen Legierung nach mindestens einem der Ansprüche 1 bis 5 zur Herstellung einer dekorativen Schicht.

**7.** Verwendung einer homogenen einphasigen Legierung nach mindestens einem der Ansprüche 1 bis 5 zur Herstellung einer Dekorplatte.

**8.** Verwendung einer homogenen einphasigen Legierung nach mindestens einem der Ansprüche 1 bis 5 zur Herstellung einer Trägerschicht aus einer Schicht aus reinem Gold.

**9.** Dekorplatte, gebildet aus der homogenen einphasigen Legierung nach mindestens einem der Ansprüche 1 bis 5, umfassend in Massenprozent N% Gold, M% Wolfram, mit N + M = 100, M ≥ 8 und N ≥ 60.

**10.** Dekorplatte nach dem vorhergehenden Anspruch, **dadurch gekennzeichnet, dass** sie mit einer Schicht aus reinem Gold beschichtet ist.

**11.** Verfahren zur Herstellung der Legierung nach mindestens einem der Ansprüche 1 bis 5, bestehend aus der Durchführung der physikalischen Gasphasenabscheidung von Gold bzw. Wolfram und der Kondensation der Dämpfe der beiden Metalle auf einem Substrat mit einer Sputtertechnik im Diodenmodus mit einem Magnetronreaktor und einer Entladung.

**12.** Verfahren zur Herstellung einer homogenen einphasigen Legierung gemäß dem vorhergehenden Anspruch, **dadurch gekennzeichnet, dass** das Substrat zuvor mit einer Opferschicht beschichtet wurde.

**13.** Verfahren zur Herstellung einer homogenen einphasigen Legierung nach Anspruch 11 oder 12, **dadurch gekennzeichnet, dass** es mindestens einen zusätzlichen Schritt der Vakuumabscheidung einer Schicht aus reinem Gold umfasst.

## Claims

**1.** Homogeneous single-phase alloy consisting, in weight percent, of N% gold, M% tungsten, where N+M=100, M ≥ 8 and N ≥ 60, the homogeneity of the alloy being **characterized by** a single chemical phase, without the presence of clusters, precipitates or aggregates of tungsten.

**2.** Homogeneous single-phase alloy according to claim 1, **characterized in that** N ≥ 75.

**3.** Homogeneous single-phase alloy according to claim 2, **characterized in that** M ≤ 25.

**4.** Homogeneous single-phase alloy according to claim 3, **characterized in that** the alloy has a density greater than 19.2 g/cm$^3$.

**5.** Homogeneous single-phase alloy according to any of the preceding claims, **characterized in that** the alloy has a face-centered cubic crystallographic structure.

**6.** Use of a homogeneous single-phase alloy according to at least one of claims 1 to 5 for producing a decorative layer.

**7.** Use of a homogeneous single-phase alloy according to at least one of claims 1 to 5 for producing a decorative sheet.

**8.** Use of a homogeneous single-phase alloy according to at least one of claims 1 to 5 for producing a support layer for a layer of pure gold.

**9.** Decorative sheet consisting of the homogeneous single-phase alloy according to at least one of claims 1 to 5, comprising, in weight percent, N% gold, M% tungsten, where N+M=100, M ≥ 8 and N ≥ 60.

**10.** Decorative sheet according to the preceding claim, **characterized in that** the decorative sheet is coated with a layer of pure gold.

**11.** Method for preparing the alloy according to at least one of claims 1 to 5, consisting in carrying out the physical vapor deposition of gold and tungsten, respectively, and for condensing the vapors of the two metals on a substrate by means of a sputtering technique in diode mode using a magnetron reactor and a discharge.

**12.** Method for preparing a homogeneous single-phase alloy according to the preceding claim, **characterized in that** said substrate is previously coated with a sacrificial layer.

**13.** Method for preparing a homogeneous single-phase alloy according to either claim 11 or claim 12, **characterized in that** the method comprises at least one additional step of vacuum deposition of a layer of pure gold.

Fig. 1

Fig. 2

Fig. 3

Fig. 4

## RÉFÉRENCES CITÉES DANS LA DESCRIPTION

**Documents brevets cités dans la description**

- JP 2012212662 A
- CH 684616
- EP 2427582 A
- US 6863746 B
- WO 2014108848 A
- EP 2045343 A
- EP 2450461 A
- EP 1010768 A

**Littérature non-brevet citée dans la description**

- **SVEN HAMANN et al.** Synthesis of Au microwires by selective oxidation of Au-W thin-film composition spreads. *SCIENCE AND TECHNOLOGY OF ADVANCED MATERIALS,* 01 Février 2013, vol. 14 (1), ISSN 1468-6996, 015003
- Model of phase formation in ion-mixed binary alloys with positive heats of formation. **OSSI et al.** JOURNAL OF THE LESS-COMMON METALS. ELSEVIER-SEQUOIA S.A. LAUSANNE, 01 Mai 1990, vol. 160, 351-362
- **W. HILLER ; M. BUCHGEISTER ; P. EITNER ; K. KOPITZKI ; V. LILIENTHAL ; E. PEINER.** Ion Beam Mixing of Selected Binary Metal Systems with Large Positive Heats of Formation. Institut fiir Strahlen- und Kernphysik der Universitiit Bonn
- *Proceedings of Santa Fe Symposium,* 2005, 103-120